# EUROPEAN PATENT SPECIFICATION

(11) **EP 3 187 504 B1**
(45) Date of publication and mention of the grant of the patent: **29.08.2018**
(21) Application number: 15203188.6
(22) Date of filing: 30.12.2015
(51) Int. Cl.: C07F 15/04, C23C 16/00, C23C 16/18

(54) **THIOSEMICARBAZONE BASED SUPRAMOLECULAR NICKEL COMPLEXES FOR CVD APPLICATIONS**
AUF THIOSEMICARBAZON BASIERENDE SUPRAMOLEKULARE NICKELKOMPLEXE FÜR CVD ANWENDUNGEN
COMPLEXES DE NICKEL SUPRAMOLÉCULAIRE À BASE DE THIOSEMICARBAZONE POUR APPLICATIONS CVD

(43) Date of publication of application: 05.07.2017
(73) Proprietor: Istanbul Universitesi Rektorlugu, 34452 Istanbul (TR)
(72) Inventor: Güveli, Sükriye, 34320 Istanbul (TR); Bal Demirci, Tülay, 34320 Istanbul (TR); Ulküseven, Bahri, 34320 Istanbul (TR); Ozdemir, Namik, Samsun (TR)
(74) Representative: Mutlu, Aydin

(56) References cited:
- GÜVELI, SÜKRIYE, BAL-DEMIRCI, TÜLAY ET AL: "Nickel(II) complexes of ONS and ONN chelating thiosemicarbazones with triphenylphosphine co-ligands", TRANSITION METAL CHEMISTRY, KLUWER ACADEMIC PUBLISHERS, DO, vol. 34, no. 4, 19 March 2009 (2009-03-19) , pages 383-388, XP019689539, ISSN: 1572-901X
- AJAY V. GOLE ET AL: "Preparation of Nickel Sulfide Thin Films and Nanocrystallites Using Nickel Furfuraldehyde Thiosemicarbazone as Single-Source Precursor", ADVANCED MATERIALS RESEARCH, vol. 383-390, 1 November 2011 (2011-11-01) , pages 3828-3834, XP055284397, DOI: 10.4028/www.scientific.net/AMR.383-390.382 8
- PALVE ANIL M ET AL: "Synthesis and X-ray single crystal structure of a cadmium(II) acetophenone thiosemicarbazone complex and its use as a single-source precursor for the preparation of CdS nanocrystallites and thin films", POLYHEDRON, vol. 61, 7 June 2013 (2013-06-07), pages 195-201, XP028676882, ISSN: 0277-5387, DOI: 10.1016/J.POLY.2013.05.052

## Description

### Technical Field of the Invention

The present invention is related to a novel cationic thiosemicarbazone complex of nickel containing triphenylphosphine as a coligand which is synthesized through the isopropanol-assisted hydrogen transfer reaction. The current invention is further related to a method for the synthesis of said cationic thiosemicarbazone complexes of nickel involving an isopropanol-assisted hydrogen transfer reaction. In the scope of the invention, the thiosemicarbazone ligand (LH₂) and its cationic nickel complex, [Ni(LH)(PPh₃)]+X-·(CH₃)₂CHOH, were characterized by elemental analysis, IR, ¹H-NMR and UV-Vis.

### Background of the Invention

Thiosemicarbazones are of great importance because of biological, medicinal, pharmacological and analytical properties. They have more than one binding site for metal ions and their properties change depending on metal atom, coordination modes, connected aldehyde or ketone and substituents on aldehyde/ketone.

Thiosemicarbazones possess different coordination modes, can be in neutral or anionic form because of thione-thiol tautomerism and give generally neutral or rarely cationic metal complexes (Scheme 1).

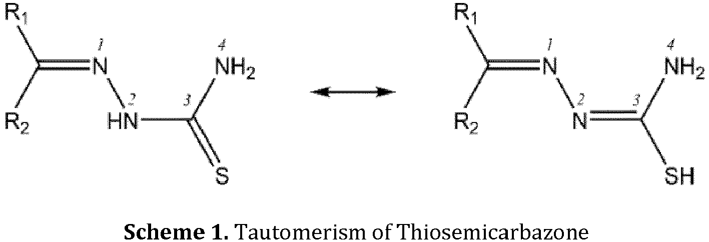

Supramolecular structures have attracted great attention in recent years and take place as a result of an intermolecular hydrogen bonding, pi-pi interactions, electrostatic effects, hydrophobic forces, metal coordination and van der Waals forces. The noncovalent interactions are extremely significant in catalysis. Although there are a great number of papers on thiosemicarbazones owning more than one donor atom, the papers are limited on supramolecular structures of metal complexes based on thiosemicarbazone.

The present invention presents the synthesis, structural, thermogravimetric and spectroscopic features of 5-bromo-2-hydroxy-benzaldeyde-S-methyl-isothiosemicarbazido triphenylphosphine nickel halide isopropyl alcohol complex. The inventors have produced a nickel complex salt form of S-methyl-isothiosemicarbazone and triphenylphosphine, which also contains one mole isopropyl alcohol as a solvent, with the formula of [Ni(LH)PPh₃]X·(CH₃)₂CHOH, as a solute-solvent complex (supramolecular structure), wherein X is a halogen, and preferably chlorine (Cl).

Thermal decomposition of this crystal showed an unexpected behaviour in oxygen and nitrogen atmosphere. The oxidative decomposition of the complex unlike nitrogen atmosphere displayed volatilization of nickel. This property is preferable for volatile solid metallo-organic precursors for use in chemical vapour deposition (CVD) applications for preparing thin films of metallic nickel (Maruyama, T. and Tago T., "Nickel thin films prepared by chemical vapour deposition from nickel acetylacetonate"J. Mater. Sci.28 (1993) 5345-5348*;* Bakovets, V.V., Mitkin, V.N., and Gelfond, N.V., "Mechanism of Ni Film CVD with a Ni (Ktfaa)2 Precursor on a SiliconSubstrate" Chem. Vapor. Depos. 11 (2005) 112-117*;* New precursors and chemistry for the growth of transition metal films by atomic layer deposition, Thomas Joseph Knisley, PhD Thesis, Wayne State University, 2012*).*

These compounds are also used as corrosion inhibitors and surfactants *(*Anti-corrosion Ability of Surfactants: A Review, Maqsood Ahmad Malik,*, Mohd Ali Hashim, Firdosa Nabi, Shaeel Ahmed AL-Thabaiti,Zaheer Khan, Int. J. Electrochem. Sci., 6 (2011) 1927-1948*)* and also as catalysts in coupling reactions *(*Discovery, Applications, and Catalytic Mechanisms of Shvo's Catalyst, Brian L. Conley, Megan K. Pennington-Boggio, Emine Boz, and Travis J. Williams, Chem. Rev. 2010, 110, 2294-2312*).* Nickel (II) complexes are particularly used as catalyst in aryl-aryl coupling reactions because the high percentage of biphenyl as the reaction product verifies this effect.

Ni(II) thiosemicarbazone complexes are known in the prior art: Güveli et al. discloses in Transition Metal Chemistry 2009, 34, 383-388 complexes with a ONN chelating ligand made from 5-Bromo-2-hydroxy-benzaldehyde and thiosemicarbazone; A. V. Gole discloses in Adv. Mat. Res. 2012, Vol. 383-390, pages 3828-3834 Nickel Furfuraldehyde thiosemicarbazone complexes for CVD applications. A. M. Palve discloses in Polyhedron 2013, 61, 195-201 Cd-semicarbazone complexes for CVD purposes.

### Brief Description of the Invention

The present invention relates to a novel nickel complex salt having the Formula **(I)** and its specific use as a volatile metallo-organic precursor in CVD applications.

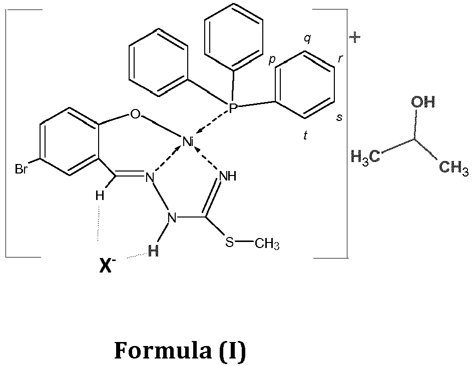

The nickel complex salt of the invention comprises S-methyl-isothiosemicarbazone, triphenylphosphine and isopropyl alcohol as a solvent which is trapped in the crystal lattice.

In another aspect, the present invention is further related to a method for the synthesis of a nickel complex salt wherein said method comprises the reaction of 5-Bromo-2-hydroxy-benzaldeyde-S-methly-isothiosemicarbazone with [Ni(PPh₃)₂X₂] in the presence of a solvent comprising isopropyl alcohol, wherein X is a halide, and particularly chlorine.

In an embodiment, the method for the nickel complex salt comprises the following steps:
- addition of [Ni(PPh₃)₂X₂] to a solution of 5-Bromo-2-hydroxy-benzaldeyde-S-methly-isothiosemicarbazone in a solvent comprising isopropyl alcohol,
- refluxing the reaction mixture and standing it for a certain period of time,
- filtering the precipitated crystals comprising [Ni(LH)(PPh₃)]⁺Cl⁻·(CH₃)₂CHOH and washing them,
wherein X is a halide, and particularly Cl.

In another embodiment of the present invention, the solvent is preferably a mixture of ethanol, isopropyl alcohol and dichloromethane. Still in a further embodiment, the volumetric ratio of ethanol:isopropylalcohol:dichloromethane is 1/3/1.

In another aspect, the present invention relates to a method for preparing thin films of metallic nickel by CVD applications where the nickel complex salt having the formula (I) given above is used as a volatile solid metallo-organic precursor.

### Brief Description of the Figures

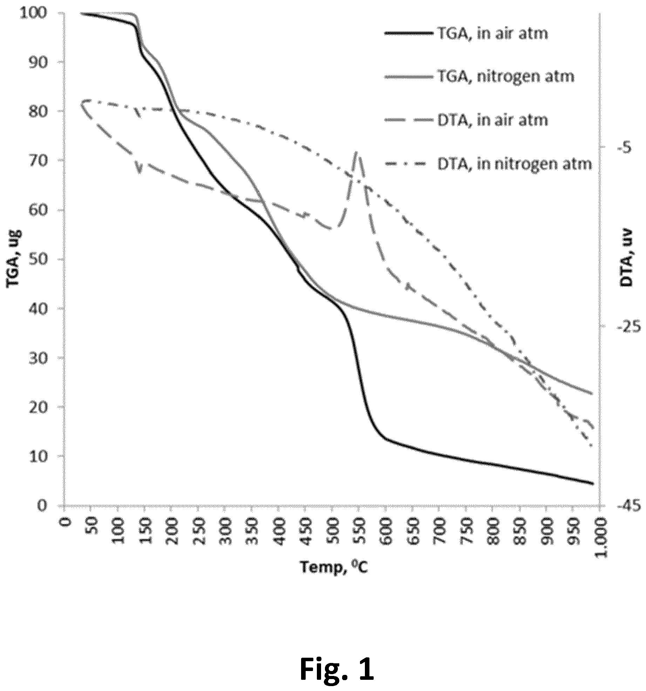

**Fig. 1** shows TGA and DTA curves of the complex according to the present invention *[TGA curves (dark solid line: in air atm., light solid line: in nitrogen atm.); DTA curves (long dash: in air atm., dash dot: in nitrogen atm.)].*

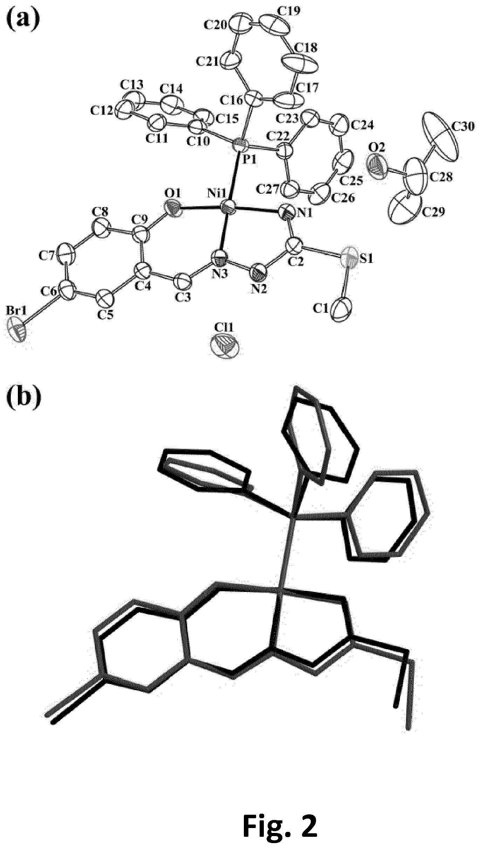

**Fig. 2** shows; **(a)** a view of the title complex showing the atom-numbering scheme whereby displacement ellipsoids are drawn at the 30% probability level and H atoms are omitted for the sake of clarity. **(b)** an atom-by-atom superimposition of the structures calculated over the X-ray structure for the cationic complex. Hydrogen atoms are omitted for clarity.

### Detailed Description of the Invention

The present invention relates to a novel nickel complex salt which can be effective upon thermal decomposition. Said complex is denominated as 5-bromo-2-hydroxybenzaldeyde-S-methly-isothiosemicarbazido triphenylphosphine nickel halide isopropyl alcohol and it is shown with the Formula (I) below.

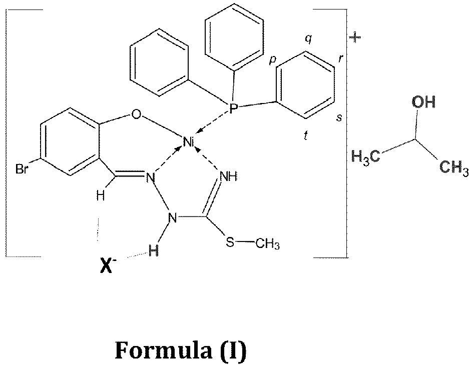

The novel complex of the present invention comprises S-methyl-isothiosemicarbazone, triphenylphosphine and isopropyl alcohol as a solvent complex. Unlike other nickel complexes comprising thiosemicarbazone, the compound of the instant invention allows the efficient catalysis of the hydrogenation transfer in the presence of isopropyl alcohol and results in the tautomeric interconversion of azinyl-azinylidene type in the presence of the co-catalyst isopropyl alcohol having appropriate polarity. Presence of isopropyl alcohol in this regard is therefore very important. In the case of the nickel complex salt disclosed in the current invention, the ionic tautomerization occurs by orientation of the double bond in azine structure in the solvent mixture advantageously selected as ethanol, isopropyl alcohol and dichloromethane, in contrast to a mixture of ethanol and dichloromethane, and azinylidene structure is formed by intramolecular proton transfer. This situation is unusual and unexpected for a thiosemicarbazone complex.

In another aspect, the present invention is further related to a method for the synthesis of a nickel complex salt wherein said method comprises the reaction of 5-Bromo-2-hydroxy-benzaldeyde-S-methly-isothiosemicarbazone with [Ni(PPh₃)₂X₂] in the presence of a solvent comprising isopropyl alcohol wherein X is a halide, and particularly chlorine.

In an embodiment, the method for the synthesis of nickel complex salt comprises the following steps:
- addition of [Ni(PPh₃)₂X₂] to a solution of 5-Bromo-2-hydroxy-benzaldeyde-S-methly-isothiosemicarbazone in a solvent comprising isopropyl alcohol,
- refluxing the reaction mixture and standing it for a certain period of time,
- filtering the precipitated crystals comprising [Ni(LH)(PPh₃)]⁺Cl⁻·(CH₃)₂CHOH and washing them.
wherein X is a halide, and particularly chlorine.

In another embodiment of the present invention, the solvent mentioned above preferably comprises a mixture of ethanol, isopropyl alcohol and dichloromethane. Still in a further embodiment, the volumetric ratio of ethanol:isopropylalcohol: dichloromethane is 1/3/1.

Furthermore, the nickel complex salt of the instant invention satisfies the need of developing a stable, non-toxic and completely volatile solid metallo-organic precursor for use in chemical vapour deposition technique.

Chemical vapour deposition is a method for deposition of nano to micro thick layers on a substrate through vapour phase chemistry. Basically in this method, the substrate is exposed to one or more volatile precursor which react and/or decompose on the substrate surface to produce the desired deposit. Hence, a material film on the substrate surface is formed by a reaction occurring when the combined gases come into contact with the substrate within the reaction chamber which is heated. The CVD technique has several benefits including the high quality of the resulting materials such as imperviousness, high purity, fine grained and increased hardness over other coating methods. Therefore, CVD method is highly preferred in the semiconductor industry and in optoelectronics due to the low costs in view of the high purity of films created. The compound of the current invention has a potential role as a precursor in the CVD technique. The nickel complex salt form of the present invention, due to its unexpected behaviour in oxygen and nitrogen atmosphere, displays nickel volatilization upon decomposition. This feature of the compound enables the use of said compound as a volatile solid metallo-organic precursor for use in CVD applications for preparing thin films of metallic nickel.

Accordingly, the current invention is further related to the use of the nickel complex salt of Formula (I) as a volatile solid metallo-organic precursor in CVD applications. Said use provides the preparation of thin films of metallic nickel.

In another aspect, the invention is further related to a method of preparation of metallic nickel thin films comprising the use of a nickel complex salt of Formula (I) as a volatile solid metallo-organic precursor.

Further aspects and advantages of the present invention will be better understood with the following examples which are merely illustrative but not limiting.

### Examples

### General Remarks

All chemicals were of reagent grad and used in the form as commercially purchased without further purification. The elemental analysis were determined on a Thermo Finnigan Flash EA 1112 Series Elemantal Analyser and Varian Spectra-220/FS Atomic Absorption Spectrometer. IR spectra of the compounds were recorded on KBr pellets with a Mattson 1000 FT-infrared spectrometer. The ¹H-Nuclear Magnetic Resonance spectra were recorded in DMSO on Bruker AVANCE- 500 model spectrometer. UV-Vis spectra were obtained with a Shimadzu 2600 UV-Visible Spectrometer as 5 x 10⁻⁵ M solutions in CHCl₃. Magnetic measurements were carried out at room temperature by the Gouy technique with an MK I model device obtained from Sherwood Scientific. The molar conductivities of the compounds were measured in 10⁻³ M DMSO solution at 25±1°C using a digital WPA CMD 750 conductivity meter. Thermal study of the complexes were carried out on a Seiko Exstar 6000 TG/DTA 6300 instrument between the 0 and 1000 °C at a heating rate of 5 °C/ min. under air and nitrogen atmosphere using platinum crucibles.

### Synthesis of 5-Bromo-2-hydroxy-benzaldeyde-S-methly-isothiosemicarbazone (L)

The ligand was prepared according to the common procedures (*Güveli* 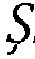 ., *Bal Demirci T., Özdemir N., Ülküseven B., "Nickel(II) Complexesof ON Sand ONN Chelating Thiosemicarbazones With Triphenylphosphine Co-Ligands", Transition Metal Chemistry, vol. 34, pp. 383-388, 2009).* The color; m.p. (°C); yield (%); elemental analysis; UV-Vis. [λₘₐₓ(ε): nm (mM⁻¹cm⁻¹); IR (cm⁻¹) and ¹H-NMR (ppm, *J* in Hz) data of the ligand were given as follows: Yellow; 199; 91; *Anal.* Calc. for C₉H₁₀BrN₃OS (288.16 g/mol): C 37.51, H 3.50, N 14.58, S 11.13, Found: C 37.53, H 3.49, N 14.57, S 11.11%; UV-Vis.: 241 (4.05), 298 (5.12), 309 (4.06), 342 (4.06), 356 (4.01); IR: *vₐ*(NH₂)3476; *vₛ*(NH₂) 3276; *v*(OH) 3084; *δ*(NH₂) 1632; *v*(C=N¹) 1620; *v*(C=N²) 1607; *v*(C-O) 1153; ¹H-NMR: 11.65, 10.79 (cis/trans ratio: 3/2, s, 1H, O*H*), 8.43, 8.33 (syn/anti ratio:2/3, s, 1H, C*H*=N¹), 7.01 (s, 2H, N⁴*H₂*), 7.76 (d-d, *J*=2.52, 1H, *c*), 7.35 (m, 1H, b), 6.86 (d-d, *J*=1.52, *J*=8.7, 1H, *a*), 2.45, 2.39 (cis/trans ratio:3/2, s, 3H, S-C*H₃*).

### Synthesis of [Ni(LH)(PPh₃)]⁺Cl⁻·(CH₃)₂CHOH

The complex was prepared with small modifications of literature method (Scheme 2) (*B*. *Ulkuseven, T. Bal-Demirci, M. Akkurt,* 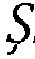 *.P. Yalcin, O. Buyukgungor, "Iron(III) and nickel(II) complexes as potential anticanceragents: synthesis, physicochemical and structural properties, cytotoxic activity and DNA interactions" Polyhedron 27 (2008) 3646-3652).* [Ni(PPh₃)₂Cl₂](0.65 g, 1 mmol) in 25 mL absolute alcohol was added to the solution of Ligand (0.29 g, 1 mmol) in a mixture of ethanol, isopropyl alcohol and dichloromethan (20 ml: 60 mL: 20mL). The reaction mixture was refluxed for 48 h. After standing for six days, the precipitated dark red crystals were filtered off and washed with n-hexan (10 ml). The color; m.p. (°C); yield (%); µ_{eff}: value (BM); molar conductivity (ohm⁻¹cm²mol⁻¹); elemental analysis; UV-Vis. [λₘₐₓ(ε): nm (mM⁻¹cm⁻¹]; IR (cm⁻¹) and ¹H-NMR (ppm. *J* in Hz, *p-t* are the symbols for the PPh₃ protons) data of the nickel complex were given as follows: Red; 177-178; 63; 0.12; 32; *Anal.* Calc. for C₃₀H₃₂BrClN₃NiO₂PS (703.68 g/mol): C 51.21, H 4.58, N 5.97, S 4.56, Found: C 51.38, H 4.41, N 6.09, S 4.62%; UV-Vis.: 239 (4.13), 263 (4.12), 355 (3.53), 386 (3.49), 406 (3.55) 529 (2.66); IR: v(NH) 3265, 3123, *δ*(NH) 1630, v(C=N) 1562, 1520, *v*(C-S) 750, *v*(PPh₃) 1435, 1100, 696, isopropyl *v*(C-H) 2965, 2920, 2814; ¹H-NMR: 11.61, 10.75 (N²*H*, 1H), 8.41, 8.30 (C*H*=N, 1H), 7.61 (s, 1H, *c*), 7.39 (brd s, 9H, *p, t, r*), 7.91, 6.99 (brd N⁴*H*, 1H), 7.35 (dd, *J*=2.44, *J*= 8.78, 1H, *b*), 7.22 (brd s, 6H, *q, s*), 6.83 (d, *J*= 8.79, 1H, *a*), 2.41 (s, 3H, *S-*C*H₃*), isopropyl alcohol: 4.30 ppm (s, 1H, O*H*), 3.75 (m, 1H, -C*H*), 1.02 (d, *J*=5.86, 6H, -C*H₃*).

### X-ray analysis

Intensity data of the complex was collected on a STOE IPDS II diffractometer at room temperature (296 K) using graphite-monochromated Mo K*α* radiation (λ=0.71073 Å) by applying the *ω*-scan method. Data collection and cell refinement were carried out using X-AREA while data reduction was applied using X-RED32 (Stoe & Cie, X-AREA Version 1.18 and X-RED32 Version 1.04, Stoe&Cie, Darmstadt, Germany, (2002)).The structure was solved by direct methods using SHELXS-2013 (G.M. Sheldrick, Acta Crystallogr. A64 (2008) 112-122) and refined with full-matrix least-squares calculations on *F*² using SHELXL-2014 (G.M. Sheldrick, Acta Crystallogr. A64 (2008) 112-122) implemented in WinGX (L.J. Farrugia, J. Appl. Crystallogr. 45 (2012) 849-854) program suit. All H atoms were inserted in idealized positions and treated using a riding model, fixing the bond lengths at 0.82, 0.86, 0.93, 0.98 and 0.96 Å for OH, NH, aromatic CH, methine CH and CH₃ atoms, respectively. The displacement parameters of the H atoms were fixed at *U*ᵢₛₒ(H) = 1.2*U*_{eq} (1.5*U*_{eq} for OH and CH₃) of their parent atoms.

### Thermal analysis

Fig. 1 shows the thermal (in nitrogen atmosphere) and thermal-oxidative decomposition (in air atmosphere) of the complex. TGA (dark solid line: in air atm., light solid line: in nitrogen atm.) and DTA (long dash: in air atm., dash dot: in nitrogen atm.) curves of the complex were obtained in the nitrogen and air atmosphere, and the curves of the complex in both atmosphere were different from each other. The thermal decompositions of the thiosemicarbazone complexes have been studied by many researchers and show similar thermal decomposition behavior. The observed trend is the formation of NiO or NiS as final residue (A. Manohar, K. Ramalingam, K. Karpagavel, Int. J. ChemTechRes. 6 (2014) 2620-2627). However, the synthesized nickel complex in this study showed unexpected behavior.

In the first decomposition step in air atmosphere, there was a weight loss of 8.60% in the region 35-147°C. The first decomposition product was isopropyl alcohol and this step was endothermic. The first decomposition step is different in nitrogen atmosphere than in air atmosphere. There was a weight loss of 6.70 % assigned to S-CH₃ part in the region 121-150°C.

It was observed an unusual state in air atmosphere. Normally, formation of metal oxides as the final residue was expected. However, volatilization of nickel took place in air atmosphere. The mass of the remaining product equals only 4.49% of the complex mass at the 986°C. This step was endothermic and completely different in the nitrogen atmosphere. The complex was thermally more stable with 22.76% remaining after 985°C in nitrogen atmosphere than in air atmosphere.

In this study, synthesized was a new supramolecular complex structure by the reaction of 5-bromo-2-hydroxy-benzaldeyde-S-methly-isothiosemicarbazone with triphenylphosphine in the presence of nickel (II) in a proper solvent mixture as stated above. The ligand and complex were characterized by a combination of FT-IR, ¹H-NMR, UV-Vis. and elemental analysis. Theoretical characterization of the ligand and complex was achieved using the density functional theory (DFT) method.

However, as noted above, regarding to the use of the compound of the invention as a precursor in CVD applications, interesting results were obtained from thermal analysis (TGA (thermogravimetric analysis) and DTA (differential thermal analysis)) of the formed complex. The findings of these analysis suggest that said compound has a good potential for being used in CVD applications for preparing thin films.

As a result, the reaction of S-methyl-isothiosemicarbazone compound and [Ni(PPh₃)₂Cl₂] gave cationic thiosemicarbazone complex chloride salt, [Ni(LH)PPh₃]Cl·(CH₃)₂CHOH. The cationic complex was successfully formed *via* hydrogen transfer. Isopropyl alcohol catalyzed efficiently the transfer hydrogenation by providing appropriate polarity media and the cationic complex is formed through interconversion azinyl-azinylidene. The spectral data and x-ray analysis proved that azinylidene structure was stabilized by intramolecular proton transfer and by intermolecular interactions and hydrogen bonding.

X-ray analysis reveals that the thiosemicarbazone ligand coordinated to nickel as a tridentate monobasic chelator *via* O,N,N atoms (Fig. 2). The crystalline lattice involves a chloride ion and an isopropyl alcohol molecule, also. The isopropyl alcohol has two acceptors (electron pairs of O atom) and only one donor (H atom), and give three hydrogen bonds. That is, H atom of the alcoholic hydroxyl group forms a hydrogen bond with Cl atom, and O atom of hydroxyl group forms two hydrogen bonds with hydrogen atoms of N1-H of thiosemicarbazone and C17-H of PPH₃. Thus, tetrahedron structure between protons of isopropyl alcohol, thiosemicarbazone and triphenylphosphine, and six-membered ring between chlorine atom and hydrogen atoms of N2-H and C3-H of thiosemicarbazone complex provide extra stability in the so formed solute-solvent complex structure. So, the structure is fixed by the hydrogen bonds. This framework is prepared from molecules "self-associate" via multiple hydrogen-bonding interactions.

The decomposition of the compound was investigated by using thermogravimetry. The synthesized nickel complex showed unexpected behavior. The oxidative thermal decomposition shows volatilizing nickel complex of thiosemicarbazone nature as unusual.

## Claims

1. A complex having Formula (I): 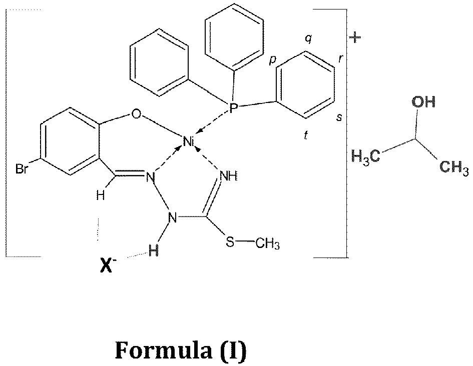 wherein X is a halide.

2. A complex according to claim 1 wherein X is chlorine.

3. A method for the synthesis of the complex according to claim 1 comprising the reaction of 5-Bromo-2-hydroxy-benzaldeyde-S-methly-isothiosemicarbazone with [Ni(PPh₃)₂X₂] in the presence of a solvent comprising isopropyl alcohol, wherein X is a halide.

4. A method according to claim 3, for the synthesis of the complex according to claim 1 comprising the steps of:
• addition of [Ni(PPh₃)₂X₂] to a solution of 5-Bromo-2-hydroxy-benzaldeyde-S-methly-isothiosemicarbazone in a solvent comprising isopropyl alcohol,
• refluxing the reaction mixture and standing it for a certain period of time,
• filtering the precipitated crystals comprising the complex having the Formula (I), wherein X is a halide.

5. A method according to claim 3 or 4 wherein X is chlorine.

6. A method according to claim 3 wherein the solvent comprises a mixture of ethanol, isopropyl alcohol and dichloromethane.

7. A method according to claim 3 or 4 wherein the volumetric ratio of ethanol:isopropylalcohol:dichloromethane is 1/3/1.

8. Use of the complex according to claim 1 as a volatile metallo-organic precursor in a CVD application.

9. The use according to claim 8 wherein said CVD application comprises deposition of Ni onto a substrate.

## Patentansprüche

1. Ein Komplex mit der Formel (I): 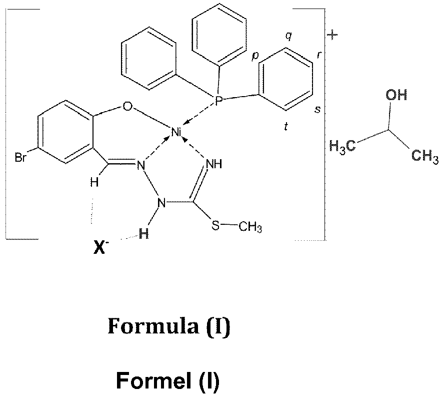 wobei X ein Halogenid ist.

2. Ein Komplex gemäß Anspruch 1, bei dem X Chlor ist.

3. Ein Verfahren zur Herstellung des Komplexes gemäß Anspruch 1, das die Reaktion von 5-Brom-2-Hydroxy-Benzaldeyd-S-Methyl-Isothiosemicarbazon mit [Ni(PPh₃)₂X₂] in Gegenwart eines Lösungsmittels, das Isopropylalkohol aufweist, wobei X ein Halogenid ist, aufweist.

4. Ein Verfahren gemäß Anspruch 3 zur Herstellung des Komplexes gemäß Anspruch 1, das folgende Schritte aufweist:
• Zugabe von [Ni(PPh₃)₂X₂] zu einer Lösung von 5-Brom-2-Hydroxy-Benzaldeyd-S-Methyl-Isothiosemicarbazon in einem Lösungsmittel, das Isopropylalkohol aufweist,
• Zum-Rückfluss-Bringen des Reaktionsgemisches und Stehenlassen desselben über einen gewissen Zeitraum,
• Filtern der gefällten Kristalle, die den Komplex mit der Formel (I) aufweisen, wobei X ein Halogenid ist.

5. Ein Verfahren gemäß Anspruch 3 oder 4, bei dem X Chlor ist.

6. Ein Verfahren gemäß Anspruch 3, bei dem das Lösungsmittel ein Gemisch aus Ethanol, Isopropylalkohol und Dichlormethan aufweist.

7. Ein Verfahren gemäß Anspruch 3 oder 4, bei dem das volumetrische Verhältnis von Ethanol:Isopropylalkohol:Dichlormethan 1/3/1 beträgt.

8. Verwendung des Komplexes gemäß Anspruch 1 als flüchtigen metallorganischen Vorläufer bei einer CVD-Anwendung.

9. Die Verwendung gemäß Anspruch 8, bei der die CVD-Anwendung eine Abscheidung von Ni auf ein Substrat aufweist.

## Revendications

1. Complexe ayant la formule (I) : 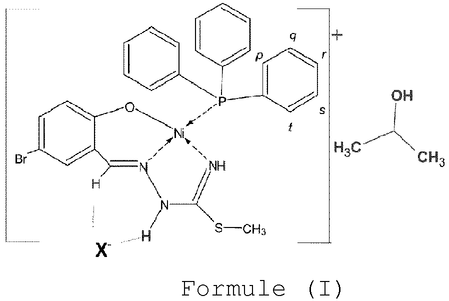 dans laquelle X est un halogénure.

2. Complexe selon la revendication 1, dans lequel X est le chlore.

3. Procédé de synthèse du complexe selon la revendication 1, comprenant la réaction de 5-bromo-2-hydroxy-benzaldéhyde-S-méthyl-isothiosemicarbazone avec du [Ni(PPh₃)₂X₂] en présence d'un solvant comprenant de l'alcool isopropylique, où X est un halogénure.

4. Procédé selon la revendication 3, pour la synthèse du complexe selon la revendication 1 comprenant les étapes de :
• addition de [Ni(PPh₃)₂X₂] à une solution de 5-bromo-2-hydroxy-benzaldéhyde-S-méthyl-isothiosemicarbazone dans un solvant comprenant de l'alcool isopropylique,
• reflux du mélange réactionnel et son repos durant une certaine période de temps,
• filtration des cristaux précipités comprenant le complexe ayant la formule (I),
où X est un halogénure.

5. Procédé selon la revendication 3 ou 4, dans lequel X est le chlore.

6. Procédé selon la revendication 3, dans lequel le solvant comprend un mélange d'éthanol, d'alcool isopropylique et de dichlorométhane.

7. Procédé selon la revendication 3 ou 4, dans lequel le rapport volumétrique d'éthanol:alcool isopropylique:dichlorométhane est de 1/3/1.

8. Utilisation du complexe selon la revendication 1 comme précurseur métallo-organique volatil dans une application CVD.

9. Utilisation selon la revendication 8, dans laquelle ladite application CVD comprend le dépôt de Ni sur un substrat.
